Europäisches Patentamt

European Patent Office  (11) Numéro de publication: **0 112 239**

Office européen des brevets  **B1**

(12)  # FASCICULE DE BREVET EUROPEEN

(45) Date de publication du fascicule du brevet: **09.03.88**  (51) Int. Cl.⁴: **H 01 L 21/90**

(21) Numéro de dépôt: **83402342.6**

(22) Date de dépôt: **05.12.83**

(54) **Procédé de positionnement d'un trou de contact électrique entre deux lignes d'interconnexion d'un circuit intégré.**

(30) Priorité: **10.12.82 FR 8220721**

(43) Date de publication de la demande:
**27.06.84 Bulletin 84/26**

(45) Mention de la délivrance du brevet:
**09.03.88 Bulletin 88/10**

(84) Etats contractants désignés:
**DE GB NL**

(56) Documents cités:
**FR-A-2 321 190**
**US-A-4 070 501**
**US-A-4 185 294**

**IBM TECHNICAL DISCLOSURE BULLETIN,
vol.24, no.12, mai 1982, pages 6421-6422, New
York, US; R.K.AGNIHOTRI et al.: "Planarization
of insulators for submicron multi-level
structures"**

(73) Titulaire: **COMMISSARIAT A L'ENERGIE
ATOMIQUE**
**31/33, rue de la Fédération**
**F-75015 Paris (FR)**

(72) Inventeur: **Jeuch, Pierre**
**49, Avenue Louis Armand**
**F-38170 Seyssins (FR)**

(74) Mandataire: **Mongrédien, André et al**
**c/o BREVATOME 25, rue de Ponthieu**
**F-75008 Paris (FR)**

EP 0 112 239 B1

Courier Press, Leamington Spa, England.

## Description

La présente invention a pour objet un procédé de positionnement d'un trou de contact électrique entre deux lignes d'interconnexion d'un circuit intégré. Ce procédé de positionnement est utilisable, en particulier, dans les procédés de fabrication de circuits intégrés MOS (métal-oxyde-semiconducteurs).

De façon plus précise, l'invention a pour objet un procédé permettant de réaliser la prise de contact électrique entre deux lignes d'interconnexion d'un circuit intégré, réalisées sur deux niveaux différents.

Les procédés de positionnement connus jusqu'à ce jour présentent un certain nombre d'inconvénients. En particulier, étant donné les imprécisions d'alignement entre les deux niveaux de masquage consécutifs, utilisés pour réaliser la prise de contact électrique, il est nécessaire d'élargir, à l'emplacement du trou de contact électrique, les deux lignes d'interconnexion.

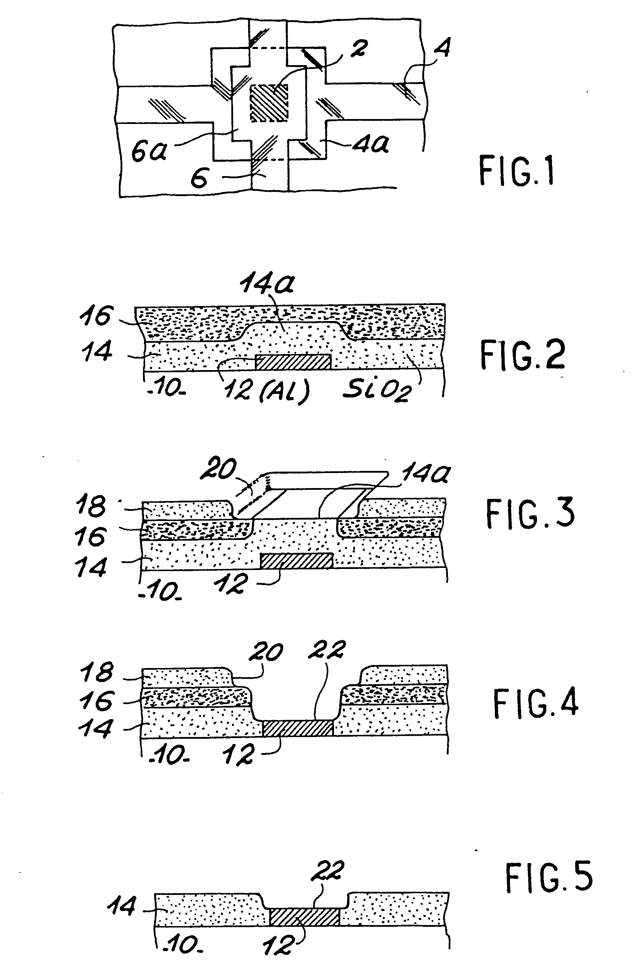

Sur la figure 1, on a représenté, en vue de dessus, selon l'art antérieur, le positionnement d'un trou de contact électrique 2 entre deux lignes d'interconnexion, une première ligne 4 et une seconde ligne 6, la première ligne 4 étant située au-dessous de la seconde ligne 6.

La présence des élargissements 4a et 6a respectivement des lignes d'interconnexion 4 et 6, limite fortement la densité d'intégration des circuits intégrés.

On connaît par ailleurs, par le document US—A—4 070 501 un autre procédé de positionnement d'un trou de contact entre deux lignes d'interconnexion.

La présente invention a justement pour objet un procédé de positionnement d'un trou de contact électrique entre deux lignes d'interconnexion d'un circuit intégré permettant de remédier à cet inconvénient. Elle permet en particulier d'augmenter la densité d'intégration des circuits intégrés d'au moins 20 %, dans certains cas, par rapport au procédé de positionnement de l'art antérieur.

Selon l'invention, le procédé de positionnement d'un trou de contact électrique entre une première ligne et une seconde ligne d'interconnexion d'un circuit intégré comprenant les étapes successives suivantes:

— réalisation de la première ligne d'interconnexion du circuit intégré,

— dépôt sur l'ensemble du circuit intégré d'une couche d'isolant,

— dépôt sur la couche d'isolant d'une première couche de matériau servant à effacer le relief de la couche d'isolant et présentant une surface plane, se caractérisé en ce qu'il comprend aussi les étapes successives suivantes:

— réalisation d'une gravure de la première couche de matériau, afin de mettre à nu la région en relief de la couche d'isolant, située au-dessus de la première ligne d'interconnexion,

— définition des dimensions du trou de contact électrique à réaliser par masquage à l'aide d'une résine,

— réalisation d'une gravure de la couche d'isolant afin de réaliser le trou de contact électrique,

— suppression du masque et élimination de la première couche de matériau restante,

— dépôt sur l'ensemble du circuit intégré d'une couche conductrice dans laquelle sera réalisée la deuxième ligne d'interconnexion,

— dépôt sur la couche conductrice d'une deuxième couche de matériau servant à effacer le relief de la couche conductrice et présentant une surface plane,

— réalisation d'une gravure de la deuxième couche de matériau afin de ne laisser du matériau qu'à l'emplacement du trou de contact électrique,

— dépôt d'une couche de résine sur le circuit intégré de façon à masquer la deuxième ligne d'interconnexion à réaliser,

— réalisation d'une gravure de la région de la couche conductrice dépourvue à la fois de résine et de la deuxième couche de matériau restante, et

— élimination de la deuxième couche de matériau restante et de la couche de résine.

Ce procédé permet d'éviter tout élargissement inutile de la première ligne d'interconnexion au niveau de la prise de contact électrique entre les deux lignes d'interconnexion.

En outre, la réalisation de la deuxième ligne d'interconnexion selon l'invention permet d'éviter tout élargissement inutile de cette deuxième ligne en dehors du trou de contact électrique permettant de connecter les deux lignes d'interconnexion.

Selon un mode de mise en oeuvre avantageux du procédé de l'invention, la première et la deuxième couches du matériau sont des couches de résine.

Selon un autre mode préféré de mise en oeuvre du procédé de l'invention, on réalise, après le dépôt des couches de matériau, un traitement thermique desdites couches afin d'améliorer la planéité de leur surface.

Selon un autre mode de mise en oeuvre avantageux du procédé de l'invention, la gravure des couches de matériau est une gravure sèche utilisant un plasma d'oxygène.

D'autres caractéristiques et avantages de l'invention ressortiront mieux de la description qui va suivre, donnée à titre illustratif mais nullement limitatif en référence aux figures annexées, sur lesquelles:

— la figure 1, déjà décrite représente, en vue de dessus, le positionnement d'un trou de contact électrique entre deux lignes d'interconnexion, selon l'art antérieur,

— les figures 2 à 9 représentent, schématiquement, les différentes étapes du procédé de positionnement d'un trou de contact conformément à l'invention; les figures 2 et 4 à 9 étant des vues selon une coupe transversale et la figure 3 étant une vue en perspective, et

— la figure 10 représente, en vue de dessus, le positionnement d'un trou de contact électrique entre deux lignes d'interconnexion, selon l'invention.

Sur la figure 2, on a représenté une partie d'un circuit intégré comprenant par exemple une zone active 10, correspondant à la source ou au drain d'un transistor MOS, que l'on veut connecter électriquement à une autre zone active (non représéntée) du circuit intégré par l'intermédiaire d'une ligne d'interconnexion 12, réalisée notamment en aluminium; cette ligne d'interconnexion 12 est réalisée de façon classique aussi bien du point de vue de son dépôt (pulvérisation magnétron) que de sa gravure (attaque chimique).

Après réalisation de la ligne d'interconnexion 12, on dépose sur l'ensemble du circuit intégré, notamment par dépôt selon la technique de dépôt chimique en phase vapeur, à basse pression ou non, une couche isolante 14, réalisée de préférence en silice pouvant contenir ou non du phosphore. Cette couche isolante 14, ayant par exemple une épaisseur uniforme de 0,8 micron, présente un profil dépendant des couches sous-jacentes; en particulier elle présente, au-dessus de la ligne d'interconnexion 12 une zone en relief 14a.

L'étape suivante du procédé consiste à déposer une couche de matériau 16 sur l'ensemble de la couche isolante 14 de façon à effacer le relief, et notamment la zone 14a, de la couche isolante 14. Cette couche de matériau 16 présentant une surface plane peut être déposée de façon classique. Cette couche de matériau 16 est de préférence réalisée en résine telle que les résines photosensibles utilisées usuellement en photogravure; dans ce cas, la couche de matériau pourra être déposée par centriguation (procédé dit de la Tournette).

Selon la viscosité de la résine utilisée, on procédera avantageusement à un traitement thermique, après dépôt de la résine, à une température permettant d'obtenir une surface aussi plane que possible grâce à un fluage de cette couche de résine 16. La résine photosensible peut être par exemple chauffée à une température de 150 à 200°C.

Il est à noter que d'autres matériaux organiques tels que les polyimides peuvent être utilisés; le dépôt et le traitement thermique de ces composés se fait de la même façon que ceux des résines photosensibles.

L'étape suivante du procédé de positionnement consiste, comme représenté sur la figure 3, à réaliser une gravure de la couche 16, notamment en résine, afine de mettre à nu la région en relief 14a de la couche isolante 14, située au-dessus de la ligne d'interconnexion 12. Cette gravure peut être réalisée par exemple à l'aide d'un procédé de gravure sèche utilisant un plasma d'oxygène. Elle permet de délimiter transversalement le trou de contact électrique à réaliser.

Après gravure de la couche 16, on masque le circuit intégré à l'aide d'une résine 18 de façon à définir la position et les dimensions du trou de contact électrique que l'on veut réaliser. Ce masque 18 présente une ouverture 20 délimitant en particulier la dimension longitudinale du trou de contact électrique à réaliser.

Après ce masquage, on réalise une gravure de la couche isolante 14 afin de réaliser le trou de contact électrique 22, comme représenté sur la figure 4. Cette gravure de la couche isolante 14 est réalisée pour les régions de ladite couche non protégées par le masque 18 ou non protégées par la couche de matériau 16. Cette gravure peut être réalisée de façon isotrope par une simple attaque chimique, HF dilué dans le cas d'une couche d'isolant en silice, ou bien par une gravure sèche anisotrope telle qu'une gravure ionique réactive, utilisant un plasma de $CHF_3$ dans le cas d'une couche d'isolant en silice.

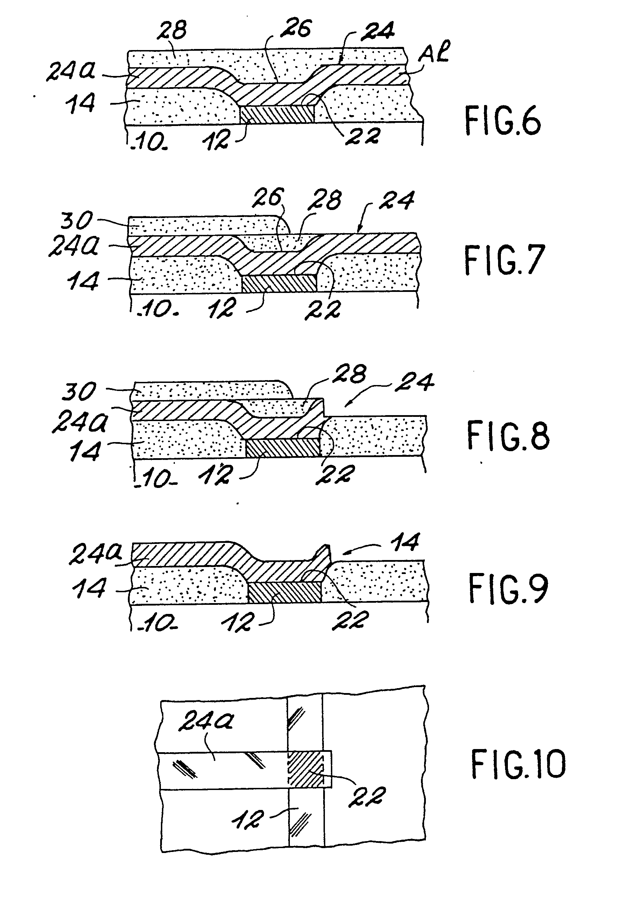

Comme représenté sur la figure 5, l'étape suivante du procédé consiste à supprimer la résine 18 servant de masque et la couche de matériau 16 restante, notamment en résine, en utilisant par exemple un plasma d'oxygène.

Les étapes suivantes du precédé selon l'invention, concernent la réalisation de la deuxième ligne d'interconnexion. La réalisation de cette deuxième ligne d'interconnexion consiste tout d'abord à déposer de façon connue, par exemple par la technique de dépôt par pulvérisation magnétron sur l'ensemble du circuit intégré une couche conductrice 24, réalisée notamment en aluminium. Cette couche conductrice qui présente une épaisseur constante (de l'ordre de 1 micron), présente un profil dépendant des couches sous-jacentes; en particulier elle présente un creux 26 dans la région du trou de contact électrique 22.

Après dépôt de la couche conductrice 24, on dépose de façon classique une couche de matériau 28 sur l'ensemble de ladite couche conductrice. Cette couche de matériau 28 qui présente une surface plane est réalisée de préférence en résine telle que celle utilisée usuellement en photogravure. Comme pour la couche de matériau 16, cette couche 28 réalisée en résine pourra être déposée par centrifugation. De même, selon sa viscosité on procédera avantageusement à un traitement thermique, après dépôt, permettant de faire fluer ladite couche de résine 28 pour améliorer la planéité de sa surface. Pour une résine photosensible, on pourra utiliser un chauffage de 150 à 200°C.

L'étape suivante de la réalisation de la deuxième ligne d'interconnexion consiste à graver la couche de matériau 28, notamment en résine, de façon à ne laisser du matériau qu'à l'emplacement du trou de contact électrique 22, c'est-à-dire dans la région en creux 26 de la couche conductrice 24, comme représenté sur la figure 7. Cette gravure peut être réalisée par exemple avec un procédé de gravure sèche utilisant un plasma d'oxygène.

Après gravure de la couche de résine 28, on réalise le masquage de la deuxième ligne d'interconnexion, portant la référence 24a, en déposant une couche de résine photosensible 30 dans laquelle on a réalisé l'image de la ligne d'interconnexion, selon les procédés classiques de la photogravure.

Comme représenté sur la figure 8, l'étape suivante de réalisation de la deuxième ligne d'interconnexion 24a consiste à graver la région de la couche conductrice 24 dépourvue à la fois de la couche de résine 30 et des résidus de la couche de résine 28, les couches de résine 30 et 28 servant de masque à ladite gravure. Cette gravure peut être réalisée de façon isotrope par une simple attaque chimique dans une solution contenant de l'acide phosphorique $H_3PO_4$, dans le cas d'une couche conductrice 24 réalisée en aluminium. Dans le cas de dimensions très petites, on utilisera, de préférence, un procédé de gravure anisotrope utilisant un plasma composé par exemple de $CCl_4$.

La dernière étape du procédé de positionnement selon l'invention consiste à éliminer les couches de résine 30 et 28 restantes, en utilisant, par exemple, un plasma d'oxygène. La structure finale est représentée sur la figure 9.

Le procédé de positionnement décrit précédemment permet d'éviter tout élargissement des deux lignes d'interconnexion 12 et 24a, au niveau du trou de contact électrique 22. Le procédé selon l'invention permet d'obtenir la structure idéale représentée sur la figure 10 qui montre, en vue de dessus, le positionnement du trou de contact électrique 22 entre les deux lignes d'interconnexion 12 et 24a. Le fait d'éviter tout élargissement des deux lignes d'interconnexion permet de réaliser, par rapport au procédé de positionnement de l'art antérieur, un gain significatif sur la densité d'intégration du circuit intégré.

**Revendications**

1. Procédé de positionnement d'un trou de contact électrique (22) entre une première ligne (12) et une seconde ligne (24a) d'interconnexion d'un circuit intégré, comprenant les étapes successives suivantes:

— réalisation de la première ligne d'interconnexion (12) du circuit intégré,

— dépôt sur l'ensemble du circuit intégre d'une couche d'isolant (14),

— dépôt sur la couche d'isolant (14) d'une première couche de matériau (16) servant à effacer le relief de la couche d'isolant et présentant une surface plane,

caractérisé en ce qu'il comprend encore les étapes successives suivantes:

— réalisation d'une gravure de la première couche de matériau (16), afin de mettre à nu la région en relief (14a) de la couche d'isolant (14), située au-dessus de la première ligne d'interconnexion (12);

— définition des dimensions du trou de contact électrique à réaliser (22) par masquage à l'aide d'une résine (18),

— réalisation d'une gravure de la couche d'isolant (14) afin de réaliser le trou de contact électrique,

— suppression du masque (18) et élimination de la première couche de matériau restante (16),

— dépôt sur l'ensemble du circuit intégré d'une couche conductrice (24), dans laquelle sera réalisée la deuxième ligne d'interconnexion (24a),

— dépôt sur la couche conductrice (24) d'une deuxième couche de matériau (28) servant à effacer le relief de la couche conductrice et présentant une surface plane,

— réalisation d'une gravure de la deuxième couche de matériau (28) afin de ne laisser du matériau qu'à l'emplacement du trou de contact électrique (22),

— dépôt d'une couche de résine (30) sur le circuit intégré de façon à masquer la deuxième ligne d'interconnexion à réaliser (24a),

— réalisation d'une gravure de la région de la couche conductrice (24) dépourvue à la fois de résine (30) et de la deuxième couche de matériau restante (28), et

— élimination de la deuxième couche de matériau restante (28) et de la couche de résine (30).

2. Procédé de positionnement selon la revendication 1, caractérisé en ce que la première et la deuxième couches de matériau (16, 28) sont des couches de résine.

3. Procédé de positionnement selon la revendication 1 ou 2, caractérisé en ce que l'on réalise, après le dépôt des couches de matériau (16, 28), un traitement thermique desdites couches afin d'améliorer la planéité de leur surface.

4. Procédé de positionnement selon l'une quelconque des revendications 1 à 3, caractérisé en ce que la gravure des couches de matériau (16, 28) est une gravure sèche utilisant un plasma d'oxygène.

5. Procédé de positionnement selon l'une quelconque des revendications 1 à 4, caractérisé en ce que la couche d'isolant (14) est une couche de silice.

**Patentansprüche**

1. Verfahren zur Positionierung eines Loches für einen elektrischen Kontakt (22) zwischen einer ersten (12) und einer zweiten Verbindungslinie (24a) einer integrierten Schaltung, welches die folgenden, aufeinanderfolgenden Schritte umfaßt:

— Herstellen der ersten Verbindungslinie (12) des integrierten Schaltkreises,

— Aufbringen einer Isolierschicht (14) auf der Gesamtheit des integrierten Schaltkreises,

— Aufbringen einer ersten Materialschicht (16) auf die Isolierschicht (14), die dazu dient, das Relief der Isolierschicht auszugleichen, und eine ebene Oberfläche aufweist,

dadurch gekennzeichnet, daß das Verfahren ferner die folgenden, aufeinanderfolgenden Schritte aufweist:

— Durchführen einer Ätzung der ersten Materialschicht (16), um den Reliefbereich (14a) der Isolierschicht (14) freizulegen, der sich über der ersten Verbindungslinie (12) befindet;

— Festlegen der Abmessungen des Loches für den herzustellenden elektrischen Kontakt (22) durch Maskierung mittels eines Harzes (18),

— Durchführen einer Ätzung der Isolierschicht (14), um das Loch für den elektrischen Kontakt herzustellen,

— Entfernen der Maske (18) und der ersten, verbliebenen Materialschicht (16),

— Aufbringen einer Leiterschicht (24) auf der Gesamtheit des Schaltkreises, in der die zweite Verbindungslinie (24a) hergestellt wird,

— Aufbringen einer zweiten Materialschicht (28) auf die Leiterschicht (24), die dazu dient, das Relief der Leiterschicht auszugleichen, und eine ebene Oberfläche aufweist,

— Durchführen einer Ätzung der zweiten Materialschicht (28), damit Material nur an der Stelle des Lochs für den elektrischen Kontakt (22) übrigbleibt,

— Aufbringen einer Harzschicht (30) auf die integrierte Schaltung derart, daß die zweite, herzustellende Verbindungslinie (24a) maskiert wird,

— Durchführen einer Ätzung des Bereiches der Leiterschicht (24), von der zugleich das Harz (30) und die zweite, verbliebene Materialschicht (28) entfernt ist, und

— Entfernen der zweiten, verbliebenen Materialschicht (28) und der Harzschicht (30).

2. Positionierungsverfahren nach Anspruch 1, dadurch gekennzeichnet, daß die erste und die zweite Materialschicht (16, 28) Harzschichten sind.

3. Positionierungsverfahren nach Anspruch 1 oder 2, dadurch gekennzeichnet, daß man nach dem Aufbringen der Materialschichten (16, 28) eine Wärmebehandlung dieser Schichten durchführt, um die Ebenheit ihrer Oberflächen zu verbessern.

4. Positionierungsverfahren nach einem der Ansprüche 1 bis 3, dadurch gekennzeichnet, daß das Ätzen der Materialschichten (16, 28) ein Trockenätzen unter Verwendung eines Sauerstoffplasmas ist.

5. Positionierungsverfahren nach einem der Ansprüche 1 bis 4, dadurch gekennzeichnet, daß die Isolierschicht (14) eine Siliciumschicht ist.

**Claims**

1. Process for the positioning of an electric contact hole (22) between a first interconnection line (12) and a second interconnection line (24a) of an integrated circuit, comprising the following successive stages:

— construction of the first interconnection line (12) of the integrated circuit,

— deposition on the entire integrated circuit of a layer (14) of insulating material,

— deposition on the insulating material layer (14) of a first layer (16) of material serving to eliminate the relief of the insulating material layer and having a plane surface,

characterized in that it comprises in addition the following successive stages:

— effecting the etching of the first layer (16) of material in order to expose the region in relief (14a) of the insulating material layer (14) situated above the first interconnection line (12);

— definition of the dimensions of the electric contact hole (22) to be made, by masking with the aid of a resin (18),

— effecting the etching of the insulating material layer (14) in order to form the electric contact hole,

— removal of the mask (18) and elimination of the remainder of the first layer (16) of material,

— deposition on the entire integrated circuit of a conductive layer (24) in which the second interconnection line (24a) will be made,

— deposition on the conductive layer (24) of a second layer of material (28) serving to eliminate the relief of the conductive layer and having a plane surface,

— effecting the etching of the second layer (28) of material in order to leave material only at the site of the electric contact hole (22),

— deposition of a layer (30) of resin on the integrated circuit so as to mask the second interconnection line (24a) which is to be made,

— effecting the etching of the region of the conductive layer (24) which is free from resin (30) and also from the remaining second layer (28) of material, and

— eliminating the remaining second layer of material (28) and the resin layer (30).

2. Positioning process according to Claim 1, characterized in that the first and second layers (16, 28) of material are layers of resin.

3. Positioning process according to Claim 1 or 2, characterized in that after the deposition of the layers (16, 28) of material these layers are subjected to heat treatment in order to improve the flatness of their surfaces.

4. Positioning process according to any one of Claims 1 to 3, characterized in that the etching of the layers (16, 28) of material consists of dry etching utilizing an oxygen plasma.

5. Positioning process according to any one of Claims 1 to 4, characterized in that the insulating material layer (14) is a layer of silica.

**FIG.1**

**FIG.2**

**FIG.3**

**FIG.4**

**FIG.5**

FIG.6

FIG.7

FIG.8

FIG.9

FIG.10